# EUROPEAN PATENT APPLICATION

(11) **EP 4 851 713 A1**
(43) Date of publication of application: **09.12.2026**
(21) Application number: 25181411.7
(22) Date of filing: 06.06.2025
(51) Int. Cl.: G03F 7/00

(54) **LITHOGRAPHIC PROCESS CALIBRATION CONTROL**

(71) Applicant: ASML Netherlands B.V., 5500 AH Veldhoven (NL)
(72) Inventor: LI, Suwen, 5500 AH Veldhoven (NL); VAN HAREN, Richard Johannes Franciscus, 5500 AH Veldhoven (NL); WERKMAN, Roy, 5500 AH Veldhoven (NL); OTTEN, Ronald Henricus Johannes, 5500 AH Veldhoven (NL)
(74) Representative: ASML Netherlands B.V.

(57) **Abstract**

There is provided a method of determining a calibration for a tool used in a lithographic process, the method comprising: obtaining a first model component for modelling a substrate distortion, said substrate distortion dependent on physical properties of a substrate type to be processed; obtaining parameter of interest data of a monitoring substrate of the substrate type; obtaining a model for modelling the parameter of interest data comprising: the first model component for modelling a substrate type dependent contribution to the parameter of interest data; and a second model component for modelling a contribution to the parameter of interest data independent of the substrate type dependent contribution; and determining the calibration based on the second model component.

## Description

### FIELD

The present invention relates to methods of calibrating a tool used in a lithographic process for semiconductor manufacture, a semiconductor manufacturing processes, a lithographic cell and associated computer program products.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm deep ultraviolet (DUV), 193 nm deep ultraviolet (DUV) and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a DUV lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

The calibration of a lithographic apparatus is vital to meet tight manufacturing specifications. To this end, monitor wafers are periodically processed on lithographic apparatus in a process known as recurrent monitoring for stability control of the lithography apparatus. In some cases, a performance change and /or drift in a lithographic apparatus may result from a stage position measurement (SPM) drift, sensor drift, wafer table degradation (i.e., a physical or mechanical degradation of components), and the like. Additionally, a substrate shape may change upon being loaded into a tool during a lithographic process, a so-called wafer load grid. In addition to data related to lithography apparatus performance changes and/or drifts, measurements acquired during monitoring and processing may also comprise a data component related to said wafer load grid which may adversely affect any calibrations determined therefrom. It is desirable to have improved methods for determining a calibration for a lithographic apparatus that are insensitive to said wafer load grid measurement component.

### SUMMARY

Embodiments of the invention are disclosed in the claims and in the detailed description.

In a first aspect there is provided a method of determining a calibration for a tool used in a lithographic process, the method comprising: obtaining a first model component for modelling a substrate distortion, said substrate distortion dependent on physical properties of a substrate type to be processed; obtaining parameter of interest data of a monitoring substrate of the substrate type; obtaining a model for modelling the parameter of interest data comprising: the first model component for modelling a substrate type dependent contribution to the parameter of interest data; and a second model component for modelling a contribution to the parameter of interest data independent of the substrate type dependent contribution; and determining the calibration based on the second model component.

In a second aspect there is provided a semiconductor manufacturing process comprising a method for determining a calibration for a tool used in a lithographic process according to the method of the first aspect.

In a third aspect there is provided a computer program product comprising machine readable instructions for causing a general-purpose data processing apparatus to perform the steps of the method according to the first aspect.

In a fourth aspect there is provided a computer readable medium comprising the computer program product of the third aspect.

In a fifth aspect there is provided a processing device comprising: at least one processor; and
the computer readable medium of the fourth aspect.

In a sixth aspect there is provided a lithographic cell comprising: a lithographic apparatus; a measurement apparatus; and the processing device of the fifth aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic overview of control mechanisms in a lithographic process utilizing a scanner stability module;
- Figure 5 depicts the wafer load grid of three different substrates having different crystal orientations in accordance with some embodiments; and
- Figure 6 depicts a method of determining a calibration for a lithographic apparatus in accordance with some embodiments.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

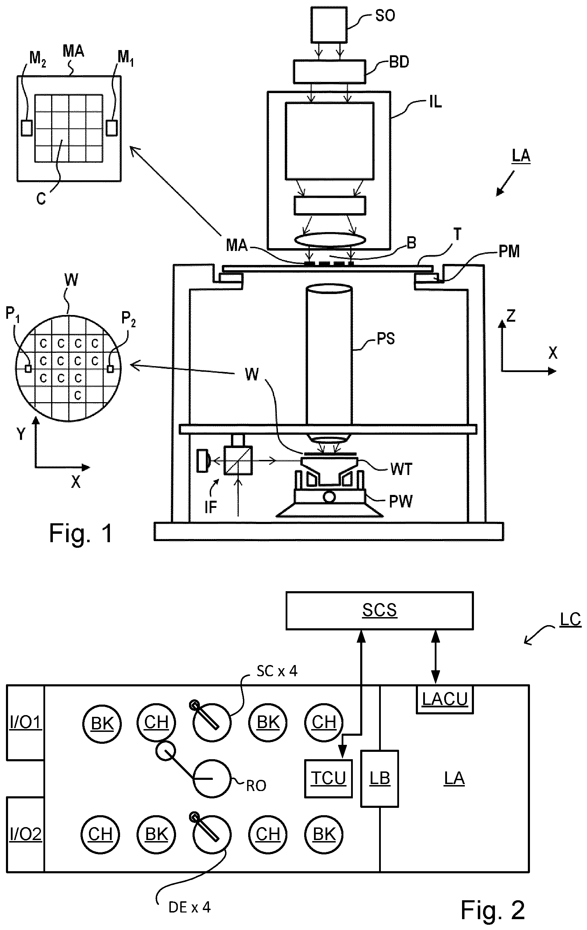

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

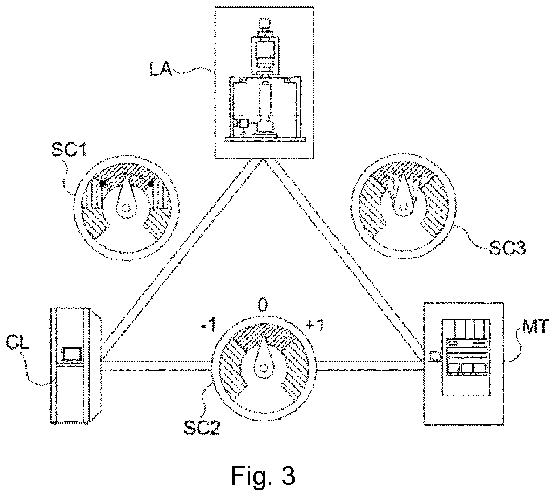

Typically, the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

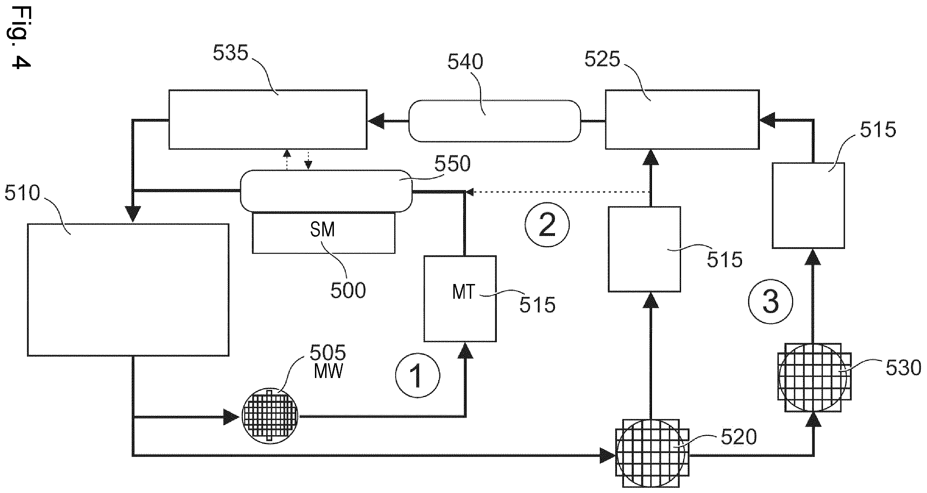

Figure 4 depicts the overall lithography and metrology method incorporating a stability module (SM) 500 (essentially an application running on a server, in this example). Shown are three main process control loops, labeled 1, 2, 3. The first loop provides recurrent monitoring for stability control of the lithography apparatus using the stability module 500 and monitor wafers. A monitor wafer (MW) 505 is shown being passed from a lithography cell or a lithographic apparatus 510, having been exposed to set the baseline parameters for focus and/or overlay. At a later time, metrology tool (MT) 515 reads these baseline parameters, which are then interpreted by the stability module 500 so as to calculate correction routines so as to provide scanner feedback 550, which is passed to the main lithography apparatus 510, and used when performing further exposures. The exposure of the monitor wafer may involve printing a pattern of marks on top of reference marks. By measuring overlay error between the top and bottom marks, deviations in performance of the lithographic apparatus can be measured, even when the wafers have been removed from the apparatus and placed in the metrology tool. The determined overlay error enables determination of calibration parameters used in accurate positioning of subsequent substrates or patterns provided by the lithographic apparatus.

Typically these calibration parameters are based on applying a model (for example comprising polynomial base functions defined across the substrate) to the measurement data to obtain model parameters used to describe a grid of the lithographic tool. The grid definition is used in positioning the substrate such that patterns are provided at correct positions on the wafers. The calibration parameters may be calculated by the stability module (SM) 500 so as to provide feedback 550, which is passed to the lithography apparatus 510, and used when performing further exposures to pattern production wafers.

The second (APC) loop is for local scanner control on-product (determining focus, dose, and/or overlay on product wafers). The exposed product wafer 520 is passed to metrology unit 515 where information relating for example to parameters such as critical dimension, sidewall angles and overlay is determined and passed onto the Advanced Process Control (APC) module 525. This data is also passed to the stability module 500. Process corrections 540 are made before the Manufacturing Execution System (MES) 535 takes over, providing control of the main lithography apparatus 510, in communication with the scanner stability module 500.

The third control loop is to allow metrology integration into the second (APC) loop (e.g., for double patterning). The post etched wafer 530 is passed to metrology unit 515 which again measures parameters such as critical dimensions, sidewall angles and overlay, read from the wafer. These parameters are passed to the Advanced Process Control (APC) module 525. The loop continues the same as with the second loop.

The subject of the present disclosure relates to the first loop; calibration of the lithographic apparatus based on periodic measurement on reference substrates which are provided with reference features. As stated before the periodic measurements are typically overlay measurements which are recorded as a wafer map comprising a grid of overlay measurements (which may be represented as overlay residuals). The reference features are etched in the reference substrate and the patterned features are provided in close proximity to the reference features, for example in a photoresist layer on top of the reference features. Often the reference features are configured as bottom gratings of an overlay mark and the patterned features are configured as the top grating of said overlay mark. The overlay mark as such is then composed of two gratings on top of each other. The overlay measurements may be performed by the metrology tool 515 and relate to the relative position of the patterned features with respect to the reference features. A properly calibrated lithographic apparatus would have positioned the patterned features at a correct position relative to its corresponding reference features. In case the positioning (sub)systems of the lithographic apparatus have drifted the overlay measurements would pick up a change in overlay between the patterned and reference features. The measured overlay errors are subsequently used to (re-)calibrate the positioning systems of the lithographic apparatus by correcting its internal grid used in controlling the substrate position and/or image positioning systems (such as controllers of the projection lens).

Thus, at a predetermined interval (e.g., 3 days), a monitor wafer is exposed on the scanner and measured on the metrology tool. A calculation is performed on measured overlay, for example using a combination of models, to determine a correction. A calculated correction request is then fed back to the scanner to correct the scanner change and/or drift.

In some cases, the scanner change and /or drift results from a stage position measurement (SPM) drift, sensor drift, wafer table degradation (i.e., a physical or mechanical degradation of components), and so on. In the case of wafer table degradation, a clamping fingerprint (i.e., a distortion of the wafer shape caused by said clamping, the so-called wafer load grid (WLG)) of the monitor wafer changes.

The mechanism behind clamping induced distortion of a substrate is related to the loading process. First the substrate is supported by so-called e-pins which hold it at multiple positions, e.g. three positions. Therefore, the weight of the substrate causes it to distort and it is desirable that this distortion be released before exposures. On the other hand, it is desirable that the substrate be held very firmly during exposure. There are two reasons for this. Firstly, the substrate is subjected to very large accelerations during an exposure sequence in order to achieve a high throughput and must not move on the substrate holder. Secondly, the substrate absorbs energy from the projection beam during exposure and therefore heats up locally. Such local heating can cause thermal expansion causing slip between substrate and burls leading to overlay errors. By holding the substrate firmly to the substrate holder such distortion can be resisted.

Two clamping techniques are commonly used. In vacuum-clamping a pressure differential across the substrate is established, e.g., by connecting the space between the substrate holder and the substrate to an under-pressure that is lower than a higher pressure above the substrate. The pressure difference gives rise to a force holding the substrate to the substrate holder. In electrostatic clamping, electrostatic forces are used to exert a force between the substrate and the substrate holder. Several different arrangements are known to achieve this. In one arrangement a first electrode is provided on the lower surface of the substrate and a second electrode on the upper surface (also referred to as the clamp surface) of the substrate holder. A potential difference is established between the first and second electrodes. In another arrangement two semi-circular electrodes are provided on the substrate holder and a conductive layer is provided on the substrate. A potential difference is applied between the two semi-circular electrodes so that the two semi-circular electrodes and the conductive layer on the substrate act like two capacitors in series.

The typical WLG drift of a monitor wafer is a diamond-like fingerprint related to the crystalline orientation (e.g., (100), (110), (111) and so on) and Young's modulus of the substrate that has an angular dependence. The angular dependence of a crystalline orientation of a substrate such as Si (110) or Si (111) is expected to be different, thus resulting in a different WLG fingerprint.

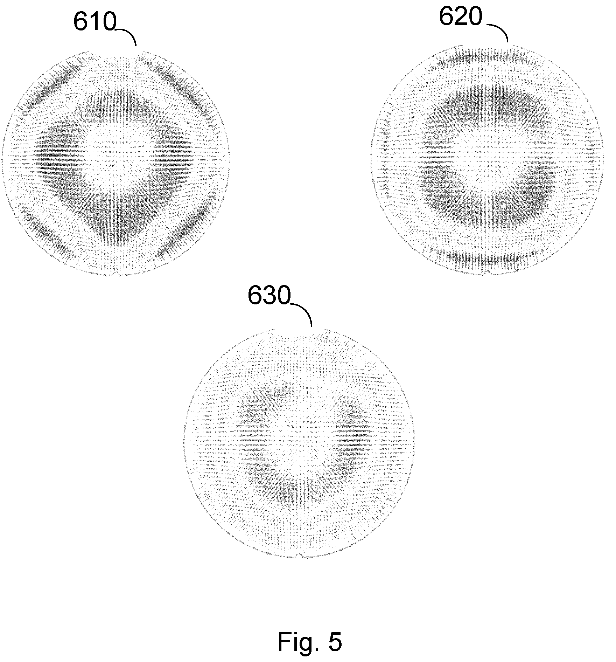

Figure 5 shows overlay maps for three clamped substrates of different crystal orientations: (100) substrate 610; (110) substrate 620; and (111) substrate 630. The overlay map is representative of the WLG (i.e., clamping induced deformation) which can be observed as substantially diamond shaped for the (100) oriented substrate 610, substantially square shaped for the (110) oriented substrate 620, and substantially triangular shaped for the (111) oriented substrate. A (111) oriented substrate has been shown to be the least sensitive to WLG and is thus a preferable substrate orientation in some embodiments. A (100) oriented substrate is the most common and/or the cheapest substrate in semiconductor industry and is thus a preferable substrate orientation in some embodiments.

How the WLG changes may also depends on the monitor wafers' properties such as backside properties and free-form wafer shapes, which also applies to on-product wafers (i.e., processed wafers comprising semiconductor devices). Typically, on-product wafers have gone through many fabrication processes such that their backside properties as well as free-form wafer shape are substantially different from monitor wafers. As a result, the WLG and its change are also different between the monitor wafers and the on product wafers. Thus, if WLG drift correction based on monitor wafers is fed back to the scanner, it may deteriorate on-product overlay (OPO) performance.

In other words, when clamping physically affects the monitor wafer shape (i.e., distorts the monitor wafer), the existing correction calculation method (which in some cases contains a high order (e.g., 3^{rd} or above) polynomial models) introduces the WLG of the monitor wafer into the on-product overlay.

Previously, coating monitor wafers with polysilicon has been shown to be insensitive to WLG changes. Other wafer substrate types, in particular substrates with (111) orientation have been suggested as potential WLG insensitive monitor wafers. Such wafers have a complicated preparation process, high cost, and potential reliability issues.

Accordingly, there is a desire to have WLG insensitive monitor wafers and/or WLG insensitive process control.

Aspects of the present disclosure provide for WLG insensitive process control in combination with a distinctive WLG model for any substrate monitoring wafer, wherein the model is substrate dependent. A WLG insensitive correction calculation method is described, preventing WLG of monitor wafers from being introduced into the correction and therefore on-product overlay. By virtue of the presently proposed solutions, no/less on-product overlay impact is expected from the WLG of monitor wafers.

Advantageously, it has been observed that the WLG for any substrate with a particular crystal orientation has a distinct constant shape (i.e., as described with reference to Figure 5). Thus, it is possible to obtain a substrate dependent WLG model that is representative for the WLG of a particular substrate.

Accordingly, a fixed set of parameters may be determined to represent the substrate dependent WLG. The fixed set of parameters may, for example, be from a physical model or a fitting model such as a polynomial model or Zernike model.

As described previously with reference to Figure 4, correction, or calibration, parameters are based on applying a model (for example comprising polynomial base functions defined across a substrate) to measurement data of a monitor wafer to obtain model parameters used to describe a grid of the lithographic tool. Advantageously, said fixed parameters representing the substrate dependent WLG may be taken into account when determining said correction (or calibration parameters), thus providing for a WLG insensitive correction.

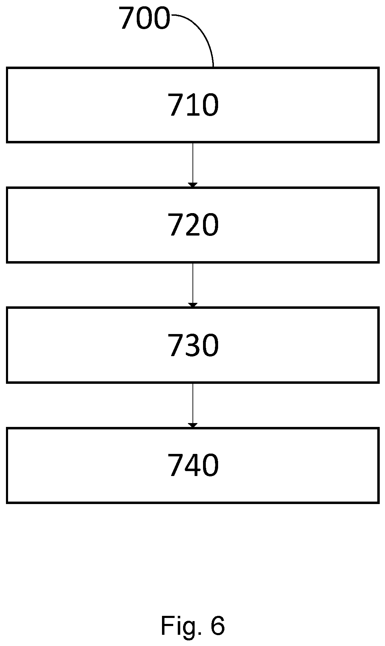

Thus, as shown in Figure 6, in a first aspect there is provided a method 700 of determining a calibration for a tool used in a lithographic process, the method comprising: obtaining 710 a first model component for modelling a substrate distortion, said substrate distortion dependent on physical properties of a substrate type to be processed. That is, based on the crystal orientation and Young's modulus of a substrate, the WLG distortion of said substrate may be modelled. This is possible because the WLG has a distinct shape dependent on substrate type that only changes in magnitude depending on, for example, clamping friction/forces when the substrate is clamped to a substrate stage. Accordingly, a fixed set of parameters describing the distortion for a particular substrate type may be determined, e.g., using a physical model or a fitting model such as a polynomial model or Zernike model.

The method further comprises obtaining 720 parameter of interest data of a monitoring substrate of the substrate type. For example, a monitoring substrate may be provided with reference features. Said monitoring substrate may be clamped in a lithographic apparatus (i.e., on a substrate table) and provided with patterned features using said lithographic apparatus. Each patterned feature may be provided in proximity to a corresponding reference feature. The position of each patterned feature may be measured relative to its corresponding reference feature. In such an example, the parameter of interest data may comprise overlay data (i.e., a difference between patterned features and reference features relative to one another).

The method further comprises obtaining 730 a model for modelling the parameter of interest data, wherein the model comprises the first model component for modelling a substrate type dependent contribution to the parameter of interest data. That is, the first model component may be used to model a component of the parameter of interest data that is dependent on the type of substrate (i.e., the WLG of the particular type of substrate).

The model further comprises a second model component for modelling a contribution to the parameter of interest data independent of the substrate type contribution. For example, the parameter of interest data may comprise the WLG component and a further component related to, for example, wafer table degradation.

The method further comprises determining 740 the calibration based on the second model component. In other words, the model comprises two model components, the first model component related to the substrate type (i.e., the WLG of a specific substrate type comprising a specific crystal orientation and Young's modulus) and the second model component independent of the substrate type. By feeding back only the model parameters corresponding to the second model component to a tool used in a lithographic process (e.g., a lithography apparatus, measurement apparatus and/or an alignment tool), a WLG insensitive calibration can be determined.

In some examples, the method may further comprise determining a coefficient K for the first model component, wherein the model comprises the first model component multiplied by the coefficient K. K may be determined such that the first model component and the second model component provide a best fit for the parameter of interest data. That is, K may be varied whilst comparing the model to the parameter of interest data in order to determine a value of K such that the model accurately represents the parameter of interest data. Any suitable regression analysis may be employed to this end (e.g., polynomial, least squares and the like). In some examples, best fit may be determined by comparing the model to the parameter of interest data and observing residual values whilst varying the K parameter in order to find the K parameter that corresponds to the lowest residual values.

In some examples coefficient K comprises a vector, wherein different elements in the vector act on different subsets of parameters of the first model component. For example, the first model component may comprise Zernike parameters up to the 7^{th} order and their corresponding coefficients may be represented by a vector.

Although not fed back to e.g., a scanner or a measurement tool (i.e., for determining the calibration), said K coefficient may be used for monitoring purposes (e.g., to monitor wafer table conditions). For example, a higher magnitude of K coefficient may indicate a degraded wafer table.

In some examples, the calibration may comprise calibrating a grid of a lithographic apparatus based on parameters of the second model component associated with positioning of substrates by the lithographic apparatus.

Examples and embodiments may be implemented in a semiconductor manufacturing process comprising a method for determining a calibration for a tool used in a lithographic process according to the method described with reference to Figures 5 and 6.

Examples and embodiments may be implemented in a computer program product comprising machine readable instructions for causing a general-purpose data processing apparatus to perform the steps of the method as described with reference to Figures 5 and 6.

Examples and embodiments may be implemented by a lithographic cell comprising: a lithographic apparatus; and, a measurement apparatus such as described with reference to Figure 2.

Further embodiments are disclosed in the subsequent list of numbered clauses:
1. A method of determining a calibration for a tool used in a lithographic process, the method comprising:
   obtaining a first model component for modelling a substrate distortion, said substrate distortion dependent on physical properties of a substrate type to be processed;
   obtaining parameter of interest data of a monitoring substrate of the substrate type;
   obtaining a model for modelling the parameter of interest data comprising:
      the first model component for modelling a substrate type dependent contribution to the parameter of interest data; and
      a second model component for modelling a contribution to the parameter of interest data independent of the substrate type dependent contribution; and
      determining the calibration based on the second model component.
2. The method of clause 1, wherein the first model component comprises a physical model and/or a fitting model.
3. The method of clause 2, wherein the fitting model comprises a polynomial model and/or a Zernike model.
4. The method of any preceding clause wherein the physical properties of the substrate type to be processed are any of crystal orientation and/or Young's modulus.
5. The method of clause 4, wherein the crystal orientation of the substrate is (111), (110), or (100).
6. The method of any preceding clause, wherein the monitoring substrate comprises reference and/or patterned features.
7. The method of clause 6, wherein the obtaining parameter of interest data comprises obtaining metrology data of the reference and/or patterned features.
8. The method of any of clause 6 or clause 7, wherein the parameter of interest data comprises overlay data and/or data relating to a positional parameter of the reference and/or patterned features.
9. The method of any preceding clause, wherein the step of obtaining parameter of interest data comprises measuring the monitoring substrate.
10. The method of any preceding clause, wherein the step of obtaining a model for modelling the parameter of interest data comprises determining a coefficient of the first model component such that the first model component and the second model component provide a best fit for the parameter of interest data.
11. The method of clause 10, wherein the coefficient of the first model component comprises a vector, and wherein different elements in the vector act on different subsets of parameters of the first model component.
12. The method of clause 10 or clause 11, further comprising monitoring substrate table conditions based on the coefficient of the first model component.
13. The method of any preceding clause, further comprising calibrating any of a lithographic apparatus, a measurement apparatus and/or an alignment tool based on the determined calibration.
14. The method of clause 13, wherein the calibration comprises calibrating a grid of the lithographic apparatus based on parameters of the second model component, said grid associated with positioning of substrates by the lithographic apparatus.
15. The method of any preceding clause, wherein the contribution to the parameter of interest data independent of the substrate type dependent contribution is associated with any of substrate table degradation, substrate stage position measurement drift and/or sensor drift.
16. A semiconductor manufacturing process comprising a method for determining a calibration for a tool used in a lithographic process according to the method of any preceding clause.
17. A computer program product comprising machine readable instructions for causing a general-purpose data processing apparatus to perform the steps of a method as recited in any of clauses 1 to 15.
18. A computer readable medium comprising the computer program product of clause 17.
19. A processing device comprising:
   at least one processor; and
   the computer readable medium of clause 18.
20. A lithographic cell comprising:
   a lithographic apparatus;
   a measurement apparatus; and
   the processing device of clause 19.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). It is also to be noted that the term metrology apparatus or metrology system encompasses or may be substituted with the term inspection apparatus or inspection system. A metrology or inspection apparatus as disclosed herein may be used to detect defects on or within a substrate and/or defects of structures on a substrate. In such an embodiment, a characteristic of the structure on the substrate may relate to defects in the structure, the absence of a specific part of the structure, or the presence of an unwanted structure on the substrate, for example.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of physical systems such as structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of a physical structure may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of determining a calibration for a tool used in a lithographic process, the method comprising:
obtaining a first model component for modelling a substrate distortion, said substrate distortion dependent on physical properties of a substrate type to be processed;
obtaining parameter of interest data of a monitoring substrate of the substrate type;
obtaining a model for modelling the parameter of interest data comprising:
the first model component for modelling a substrate type dependent contribution to the parameter of interest data; and
a second model component for modelling a contribution to the parameter of interest data independent of the substrate type dependent contribution; and
determining the calibration based on the second model component.

2. The method of claim 1, wherein the first model component comprises a physical model and/or a fitting model.

3. The method of claim 2, wherein the fitting model comprises a polynomial model and/or a Zernike model.

4. The method of any preceding claim wherein the physical properties of the substrate type to be processed are any of crystal orientation and/or Young's modulus.

5. The method of any preceding claim, wherein the monitoring substrate comprises reference and/or patterned features.

6. The method of claim 5, wherein the obtaining parameter of interest data comprises obtaining metrology data of the reference and/or patterned features.

7. The method of any preceding claim, wherein the step of obtaining parameter of interest data comprises measuring the monitoring substrate.

8. The method of any preceding claim, wherein the step of obtaining a model for modelling the parameter of interest data comprises determining a coefficient of the first model component such that the first model component and the second model component provide a best fit for the parameter of interest data.

9. The method of claim 8, further comprising monitoring substrate table conditions based on the coefficient of the first model component.

10. The method of any preceding claim, further comprising calibrating any of a lithographic apparatus, a measurement apparatus and/or an alignment tool based on the determined calibration.

11. A semiconductor manufacturing process comprising a method for determining a calibration for a tool used in a lithographic process according to the method of any preceding claim.

12. A computer program product comprising machine readable instructions for causing a general-purpose data processing apparatus to perform the steps of a method as claimed in any of claims 1 to 10.

13. A computer readable medium comprising the computer program product of claim 12.

14. A processing device comprising:
at least one processor; and
the computer readable medium of claim 13.

15. A lithographic cell comprising:
a lithographic apparatus;
a measurement apparatus; and
the processing device of claim 14.
